# EUROPÄISCHE PATENTSCHRIFT

(11) **EP 0 906 646 B1**
(45) Veröffentlichungstag und Bekanntmachung des Hinweises auf die Patenterteilung: **22.12.1999**
(21) Anmeldenummer: 97922896.2
(22) Anmeldetag: 07.05.1997
(51) Int. Cl.: H01S 3/025

(54) **MONOLITHISCHE LASERDIODEN-MODULATOR-KOMBINATION**
MONOLITHIC LASER DIODE MODULATOR COMBINATION
COMBINAISON MONOLITHIQUE D'UNE DIODE LASER ET D'UN MODULATEUR

(30) Priorität: 19.06.1996 DE 19624514
(43) Veröffentlichungstag der Anmeldung: 07.04.1999
(73) Patentinhaber: SIEMENS AKTIENGESELLSCHAFT, 80333 München (DE)
(72) Erfinder: BORCHERT, Bernd, D-85368 Moosburg (DE); STEGMÜLLER, Bernhard, D-86163 Augsburg (DE); STEINMANN, Philipp, D-80469 München (DE)
(86) Internationale Anmeldenummer: DE9700925
(87) Internationale Veröffentlichungsnummer: WO9749149

(56) Entgegenhaltungen:
- EP-A- 0 531 214
- EP-A- 0 627 798
- US-A- 5 345 461
- US-A- 5 390 209
- WEIQUAN CHEN ET AL: "QUANTUM-CONFINED STARK SHIFT FOR DIFFERENTLY SHAPED QUANTUM WELLS" SEMICONDUCTOR SCIENCE AND TECHNOLOGY, Bd. 7, Nr. 6, 1.Juni 1992, Seiten 828-836, XP000572384 in der Anmeldung erwähnt
- P. STEINMANN ET AL: "Asymmetric quantum wells with enhanced QCSE: Modulation behaviour and application for integrated laser/modulator" IEEE PHOTONICS TECHNOLOGY LETTERS., Bd. 9, Nr. 2, Februar 1997, NEW YORK US, Seiten 191-193, XP000683863

## Beschreibung

Die vorliegende Erfindung betrifft die monolithische Integration eines Lasers und eines Modulators.

Hohe Bitraten bei der Informationsübertragung sind nur optisch realisierbar. In der Sendeeinheit werden dabei ein Monomode-Laser (z. B. ein DFB-Laser) als Lichtquelle und ein Elektroabsorptionsmodulator als Schalter verwendet. Um die notwendigen Leistungsmerkmale sowohl beim Laser als auch beim Modulator zu erreichen, werden bei beiden Komponenten Quanteneffekte ausgenutzt, die in QW-Strukturen (Quantum Well) in der aktiven Schicht auftreten. Beim Modulator wird der QCSE (Quantum Confined Stark Effect) ausgenutzt. Die monolithische Integration der Laserdiode und des Modulators ist in vielerlei Hinsicht wünschenswert. Die Einkopplungsverluste der Strahlung in den Modulator werden minimiert. Höhere Bitraten und ein geringerer Chirp (Verbreiterung des Spektrums bei Modulation) werden ermöglicht. Die Kosten für die Sendeeinheit als Ganzes sinken. Ein Problem ist dabei, daß die Energiebandlücke der QW-Struktur des Modulators größer sein muß als die Energiebandlücke des Lasers, damit keine Absorption der Strahlung in dem Modulator auftritt. Es müssen daher entweder unterschiedliche Materialzuammensetzungen oder unterschiedliche räumliche Abmessungen der Schichtstrukturen im Laser und im Modulator verwendet werden.

Zur Erzielung der erforderlichen Differenz in den Energiebandlücken von Laser und Modulator gibt es unterschiedliche Ansätze:
1. Es werden zwei Epitaxieschritte vorgenommen, in denen zunächst die QW-Struktur des Lasers gewachsen wird, diese dann auf der Seite des Modulators wieder weggeätzt wird und in einem zweiten Epitaxieschritt die QW-Struktur des Modulators gewachsen wird.
2. Es erfolgt eine selektive Epitaxie: Es werden Masken während des Epitaxieprozesses verwendet, um die Wachstumsverhältnisse in verschiedenen Bereichen der Wachstums fläche zu steuern. Das erlaubt, QW-Strukturen unterschiedlicher Schichtdicken zu wachsen.
3. Es erfolgt eine Nachbehandlung eines Teils der Oberfläche mit Ionenimplantation: Das führt zu einer Fehlordnung zwischen den Gitteratomen, die durch Temperung wieder ausgeheilt wird. Im Resultat hat sich die Bandlücke vergrößert, und dieser nachbehandelte Teil kann als Modulator verwendet werden.
4. Es kann eine gemeinsame Schichtstruktur für den Laser und den Modulator verwendet werden. Diese Schichtstruktur kann als MQW-Struktur (Multiple Quantum Well) oder als Übergitter (Super Lattice) ausgebildet sein. Bei der MQW-Struktur sind die durch die Schichtstruktur gegebenen Potential töpfe voneinander entkoppelt. Bei der Struktur mit Übergitter sind die Potentialtöpfe gekoppelt, so daß sich aufgrund des resonanten Tunneleffektes eine Aufspaltung der Energieniveaus in den Potentialtöpfen ergibt. Bei einer MQW-Struktur wird die Emissionswellenlänge des Lasers mittels eines DFB-Gitters ins Rote verstimmt, wie das in der EP 0 627 798 Al beschrieben ist. Bei Verwendung eines Übergitters tritt unter dem Einfluß eines elektrischen Feldes der Effekt der Wannier-Stark-Lokalisierung auf, so daß die Energiebandlücke größer wird (Blauverschiebung der Absorptionskante). Das wird bei dem Laser-Modulator der EP 0 531 214 B1 ausgenutzt.

Aufgabe der vorliegenden Erfindung ist es, eine einfache herstellbare monolithische Integration einer Laserdiode und eines Modulators anzugeben.

Diese Aufgabe wird mit der Laserdiode-Modulator-Kombination mit den Merkmalen des Anspruches 1 gelöst. Weitere Ausgestaltungen ergeben sich aus den abhängigen Ansprüchen.

Bei der erfindungsgemäßen Laser-Modulator-Kombination ist eine Schichtstruktur vorgesehen, von der ein Abschnitt die aktive Schicht der Laserdiode bildet und ein sich daran anschließender Abschnitt für den Modulator vorgesehen ist. Diese Schichtstruktur bildet eine MQW-Struktur mit voneinander entkoppelten Potentialtöpfen. Die einzelnen Potentialtöpfe sind durch asymmetrische QW-Strukturen zwischen Barriereschichten gebildet. Diese jeweiligen Teilschichtstrukturen besitzen daher keine Symmetrieebene parallel zu den Ebenen der Schichten. Solche asymmetrischen QW-Strukturen können einen umgekehrten QCSE zeigen. Das Anlegen eines elektrischen Feldes kann zu einer Verschiebung der Absorptionskante ins Blaue führen, d. h. die Energiebandlücke wird größer. Dieser Effekt ist entgegengesetzt zu dem bei gewöhnlichen MQW-Strukturen auftretenden QCSE, der die Absorptionskante ins Rote verschiebt. Die asymmetrischen Teilschichtstrukturen können gebildet sein durch verschiedene Schichten unterschiedlicher Materialzusammensetzung oder durch gradierte Änderungen der Materialzusammensetzung (Grading). Wenn eine solche MQW-Struktur mit voneinander entkoppelten Potentialtöpfen als gemeinsame Schichtstruktur sowohl für den Laser als auch für den Modulator eingesetzt wird, absorbiert der Modulator ohne angelegtes Feld genau bei der Wellenlänge, bei der der Laser Strahlung emittiert. Die Emissionswellenlänge des Lasers befindet sich hinter der Absorptionskante in Richtung zu kürzeren Wellenlängen. Die Verwendung derselben MQW-Struktur für den dem Laser und dem Modulator gemeinsamen Wellenleiter führt also dazu, daß ohne an den Modulator angelegtes elektrisches Feld in dieser Richtung kein Licht austritt. Bei Anlegen eines Feldes an den Modulator durch Anlegen einer elektrischen Spannung an den Modulator in der Sperrichtung bezüglich der Stromrichtung des Lasers verschiebt sich die Absorptionskante an der Emissionswellenlänge des Lasers vorbei weiter zu kurzen Wellenlängen hin. Im Bereich des Modulators wird dann nicht mehr die Wellenlänge, die der Laser emittiert, absorbiert. Es kann dann auf der Seite des Modulators die Strahlung austreten.

Es folgt eine genauere Beschreibung der erfindungsgemäßen Anordnung anhand der Figuren 1 bis 6.
- Figuren 1 bis 3: zeigen drei verschiedene Ausführungsformen der erfindungsgemäßen Anordnung im Querschnitt.
- Figuren 4 bis 6: zeigen die Energiebandschemata für verschiedene Ausführungsformen der MQW-Strukturen.

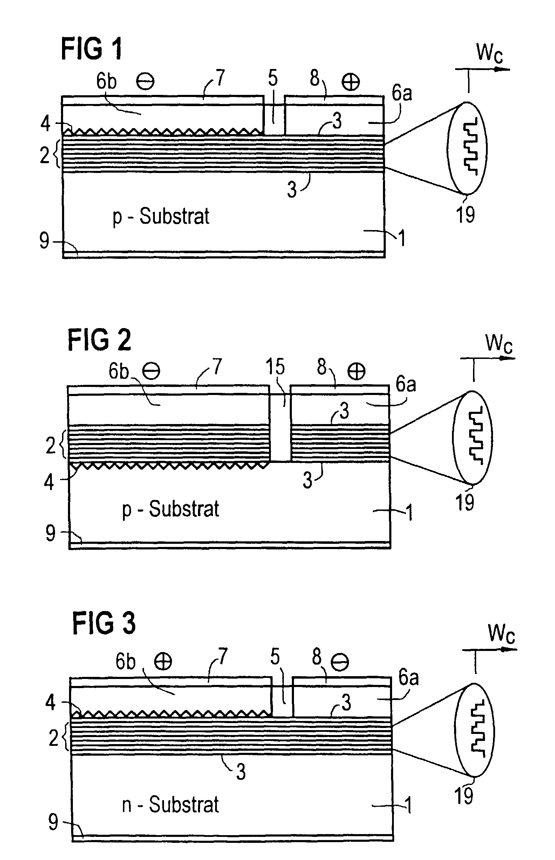

Bei der Ausführungsform der Figur 1 befindet sich eine aktive Schichtstruktur 2 auf einem Substrat 1, das hier p-leitend dotiert ist. Für die Wellenführung sind unter und über der aktiven Schichtstruktur Confinementschichten 3 angeordnet. Zur Erzeugung einer Laserresonanz und zur Modenselektion ist ein DFB-Gitter 4 (Distributed Feedback) parallel zu der aktiven Schichtstruktur in dem für die Laserdiode vorgesehenen Abschnitt angeordnet. Die aktive Schichtstruktur 2 ist vorzugsweise undotiert. Die für die Wellenführung vorgesehenen Confinementschichten 3 sind vorzugsweise ebenfalls undotiert, können aber statt dessen für den Leitfähigkeitstyp der jeweils angrenzenden Halbleiterschichten dotiert sein. Diese angrenzenden Halbleiterschichten werden im folgenden und in den Ansprüchen als Mantelschichten bezeichnet. In der vereinfachten Ausführungsform der Figur 1 wird die untere Mantelschicht einfach durch das Substrat 1 gebildet. Es können zwischen der unteren Confinementschicht 3 und dem Substrat 1 wie sonst üblich gesonderte Schichten vorhanden sein, z. B. eine die Substratoberfläche verbessernde Pufferschicht und gesonderte untere Mantelschichten. Die obere Mantelschicht umfaßt zwei getrennte Anteile 6a, 6b. Zwischen diesen Anteilen der oberen Mantelschicht befindet sich ein isolierender Bereich 5, der mindestens bis auf die obere Confinementschicht herabreicht. Die obere Mantelschicht 6a, 6b ist hier n-leitend dotiert. Vorzugsweise ist ein oberer Schichtanteil dieser oberen Mantelschicht hoch dotiert, um einen niedrigen ohmschen Widerstand zwischen dem Halbleitermaterial und den darauf aufzubringenden Metallkontakten herzustellen. Insbesondere kann eine gesonderte, hoch dotierte Kontaktschicht zusätzlich aufgewachsen sein. Auf dem über dem für Strahlungserzeugung vorgesehenen Bereich der aktiven Schichtstruktur vorhandenen Anteil der oberen Mantelschicht 6b ist ein Kontakt 7 aufgebracht. Entsprechend befindet sich ein Kontakt 8 auf dem über dem für den Modulator vorgesehenen Bereich der aktiven Schichtstruktur aufgebrachten Anteil der oberen Mantelschicht 6a. Die Gegenelektrode zu diesen Kontakten wird durch einen weiteren Kontakt 9 gebildet, der in diesem Beispiel auf der Rückseite des leitfähig dotierten Substrates aufgebracht ist. Falls eine gesonderte untere Mantelschicht vorhanden ist, kann die Stromzuführung in die aktive Schichtstruktur durch diese Mantelschicht lateral und über einen ebenfalls auf der Oberseite der Anordnung angebrachten Kontakt erfolgen. Das DFB-Gitter 4 kann statt auf der von dem Substrat abgewandten Seite auf der dem Substrat zugewandten Seite der aktiven Schichtstruktur 2 angeordnet sein. Zur Ausbildung eines Laserresonators kann ein Trenngraben zwischen dem Bereich des Lasers und dem Bereich des Modulators vorhanden sein, dessen Flanke eine für einen Laserresonator vorgesehene Spiegelendfläche bildet. Dieser Trenngraben befindet sich statt des isolierenden Bereiches 5 an dieser Stelle und reicht mindestens herab bis zu der unteren, auf der dem Substrat zugewandten Seite der aktiven Schichtstruktur angeordneten Confinementschicht.

Die aktive Schichtstruktur 2 ist als MQW-Struktur (Multiple Quantum Well) ausgebildet. Diese Schichtstruktur umfaßt mehrere, vorzugsweise 10 oder mehr, Teilschichtstrukturen, die durch Barriereschichten voneinander getrennt sind. Diese Barriereschichten sind so dick, daß die durch die einzelnen Teilschichtstrukturen zwischen den angrenzenden Barriereschichten gebildeten Potentialtöpfe voneinander entkoppelt sind. Die Materialzusammensetzungen innerhalb jeder dieser Teilschichtstrukturen ist so gewählt, daß keine Symmetrieebene parallel zur Ebene der Schichten innerhalb dieser Teilschichtstrukturen vorhanden ist, d. h. daß die Potentialtöpfe asymmetrisch sind. Innerhalb jeder Teilschichtstruktur befindet sich dasjenige Halbleitermaterial mit der Materialzusammensetzung kleinster Energiebandlücke näher zur n-leitend dotierten Mantelschicht als das restliche Halbleitermaterial derselben Teilschichtstruktur. Das ist in der Figur 1 in dem seitlich gezeichneten Diagramm 19 andeutungsweise dargestellt. Es ist dort ausschnittweise die untere Grenze W_{c} des Leitungsbandes dargestellt. Die obere Grenze Wᵥ des Valenzbandes ist dazu näherungsweise spiegelsymmetrisch zu denken. Die durch den Abstand dieser Linien gegebene Energiebandlücke ist wie erkennbar in jeder Teilschichtstruktur oben, d. h. in größerem Abstand von dem Substrat kleiner als unten. In dieser schematischen Darstellung ist als Beispiel eine zweilagige Teilschichtstruktur mit nur zwei verschiedenen Materialzusammensetzungen dargestellt.

Figur 2 zeigt ein entsprechendes Ausführungsbeispiel, bei dem das DFB-Gitter 4 auf der dem Substrat zugewandten Seite der aktiven Schichtstruktur angeordnet ist. Statt der durchgehenden aktiven Schichtstruktur 2 sind die Bereiche der Laserdiode und des Modulators durch einen Trenngraben 15 voneinander getrennt, so daß die in der Figur linke Flanke des Trenngrabens 15 eine Spiegelendfläche bildet. Für den Laser ergibt sich so eine Resonatorstruktur, so daß das DFB-Gitter 4 auch entfallen kann. Bei den Ausführungsformen der Figuren 1 und 2 wird die Potentialdifferenz zum Betrieb des Lasers entsprechend den Vorzeichen der Leitfähigkeit der Mantelschichten angelegt. An den Kontakt 7 wird daher der negative Pol, an den Kontakt 9 der positive Pol dieser Potentialdifferenz angelegt. Im Bereich des Modulators wird eine Potentialdifferenz in entgegengesetzter Richtung, d. h. bezüglich der Vorzeichen der Leitfähigkeiten der Mantelschichten in Sperrichtung, angelegt. An dem Kontakt 8 liegt daher ein Potential an, das gegenüber dem am Kontakt 9 anliegenden Potential positiv ist. Durch den Betrieb des Modulators in Sperrichtung kann bei geeignet gewählter Größe der Potentialdifferenz in den Teilschichtstrukturen der MQW-Struktur ein solches elektrisches Feld hervorgerufen werden, daß der vorstehend beschriebene umgekehrte QCSE mit einer Blauverschiebung der Absorptionskante auftritt. Bei der Ausführungsform der Figur 2, bei der auf der Oberseite der oberen Confinementschicht 3 keine weitere Struktur aufgebracht ist, kann insbesondere diese obere Confinementschicht 3 als obere Mantelschicht verwendet werden. Diese Confinementschicht wird dann n-leitend ausgebildet, und die Kontakte 7, 8 werden unmittelbar auf die Confinementschicht oder eine darauf aufgebrachte hoch dotierte Kontaktschicht aufgebracht.

Bei dem Ausführungsbeispiel der Figur 3 sind gegenüber dem Ausführungsbeispiel der Figur 1 die Vorzeichen der Dotierung umgekehrt. Das Substrat 1 ist hier n-leitend dotiert. Die obere Mantelschicht 6a, 6b ist p-leitend dotiert. Entsprechend ist im Betrieb der Anordnung das positivste Potential an den Kontakt 7 anzulegen und das negativste Potential an den Kontakt 8. Dieses Ausführungsbeispiel stellt die bevorzugte Ausführungsform der Erfindung dar. Das DFB-Gitter kann auch hier zwischen Substrat 1 und aktiver Schichtstruktur 2 angeordnet sein und bei Verwendung eines Trenngrabens ggf. weggelassen sein.

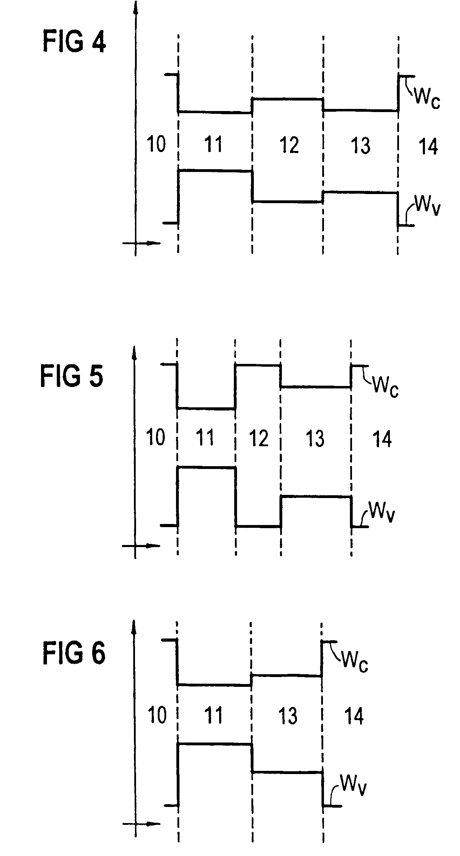

Die Figuren 4 bis 6 dienen der Erläuterung der Materialzusammensetzungen in den die Potentialtöpfe bildenden Teilschichtstrukturen. Es sind in diesen Figuren jeweils Diagramme dargestellt, in denen für je eine Teilschichtstruktur die untere Grenze des Leitungsbandes W_{c} und die obere Grenze des Valenzbandes Wᵥ dargestellt sind. Auf der Abszisse ist der Abstand von einer der Confinementschichten abgetragen. In den Beispielen der Figuren 4 und 5 besteht die Teilschichtstruktur jeweils aus einer mittleren Teilschicht 12 und zwei äußeren Teilschichten 11, 13, die zwischen Barriereschichten 10, 14 angeordnet sind. Die Änderungen der Materialzusammensetzungen erfolgen hier stufenweise. Bei dem Beispiel der Figur 6 besteht die Teilschichtstruktur nur aus zwei Teilschichten 11, 13 zwischen Barriereschichten 10, 14. Zur Vereinfachung der Schichtfolge werden die Barriereschichten vorzugsweise jeweils mit derselben Materialzusammensetzung hergestellt. Die Teilschicht mit dem geringsten Energiebandabstand (in den Beispielen jeweils die Teilschicht 11) befindet sich jeweils auf der Seite, die der n-leitend dotierten Mantelschicht zugewandt ist. Im Materialsystem von InP sind typische Materialzusammensetzungen für das Ausführungsbeispiel der Figur 4 z. B.: In_{0,8}Ga_{0,2}As_{0,2}P_{0,8} in den Barriereschichten 10, 14, In_{0,67}Ga_{0,33}AS_{0,93}P_{0,07} in der der n-leitend dotierten Seite zugewandten Teilschicht 11, In_{0,95}Ga_{0,05}As_{0,51}P_{0,49} in der der p-leitend dotierten Seite zugewandten Teilschicht 13 und In_{0,72}Ga_{0,28}As_{0,63}P_{0,37} in der mittleren Teilschicht 12; für die Ausführungsform der Figur 5: In_{0,66}Ga_{0,34}As_{0,63}P_{0,37} in den Barriereschichten 10, 14 und in der mittleren Teilschicht 12, In_{0,74}Ga_{0,26}As_{0,87}P_{0,13} in der der n-leitend dotierten Seite zugewandten Teilschicht 11 und InAs_{0,53}P_{0,47} in der der p-leitend dotierten Seite zugewandten Teilschicht 13; für die Ausführungsform der Figur 6: In_{0,87}Ga_{0,13}As_{0,51}P_{0,49} in den Barriereschichten 10, 14, In_{0,59}Ga_{0,41}As_{0,86}P_{0,14} in der der n-leitend dotierten Seite zugewandten Teilschicht 11 und InAs_{0,53}P_{0,47} in der der p-leitend dotierten Seite zugewandten Teilschicht 13. Um den der Erfindung zugrundeliegenden Effekt einer genügend großen Blauverschiebung im Bereich des Modulators zu gewährleisten, sind die Teilschichtstrukturen entsprechend der vorgesehenen Anzahl von Teilschichten und der vorgesehenen Emissionswellenlänge in ihren Materialzusammensetzungen jeweils anzupassen. Diese Anpassung geschieht entsprechend den wissenschaftlichen Erkenntnissen über das Auftreten des umgekehrten QCSE in asymmetrischen MQW-Strukturen, wie sie z. B. in der Veröffentlichung von W. Chen und T.G. Andersson: "Quantum-confined Stark shift for differently shaped quantum wells" in Semi-cond. Sci. Technol. 7, 828-836 (1992) dargelegt sind, und erfolgt z. B. rechnerisch anhand von Modellrechnungen. Für die Realisation der Erfindung kann man verschiedene Material-systeme verwenden, wie z. B. InGaAsP, AlGaAs, Antimonidverbindungen oder II-VI-Verbindungen. Bevorzugt ist das Materialsystem von InGaAsP. Daher ist die erfindungsgemäße Laserdiode-Modulator-Kombination für verschiedenste Wellenlängen realisierbar. Die monolithische Integration des Lasers mit dem Modulator durch den Einsatz einer gemeinsamen asymmetrischen MQW-Struktur in der aktiven Schicht ermöglicht daher eine einfachere und kostengünstigere Ausführung der Integration, die zudem bessere technische Merkmale als die aus dem Stand der Technik bekannten aufweist.

Im Vergleich zu integrierten Laserdiode-Modulator-Kombinationen, die in angepaßten Epitaxieschritten oder mit nachträglicher Ionenimplantation hergestellt werden, ist die erfindungsgemäße Kombination wesentlich einfacher und damit mit größerer Ausbeute an funktionsfähigen Bauelementen herstellbar. Im Vergleich zu einer derartigen Kombination mit verstimmtem Laser, d. h. einer integrierten Laserdiode, die außerhalb ihres Gewinnmaximums betrieben wird, zeichnet sich die erfindungsgemäße Kombination durch einen günstigeren Kompromiß zwischen der gewünschten Optimierung des Modulators und der Optimierung des Lasers aus, da der Laser im Gewinnmaximum betrieben werden kann. Die Verwendung eines Übergitters anstelle der erfindungsgemäßen MQW-Struktur resultiert in erheblich ungünstigeren Lasereigenschaften. Die erforderliche Vielzahl der Grenzflächen beim Übergitter erhöht die inneren Verluste, und insgesamt ist die Herstellung von Übergittern technisch aufwendiger.

## Patentansprüche

1. Monolithische Laser-Modulator-Kombination aus Halbleitermaterial,
- bei der eine für Strahlungserzeugung geeignete aktive Schichtstruktur (2) zwischen Mantelschichten (1, 6a, 6b) angeordnet ist,
- bei der eine dieser Mantelschichten n-leitend dotiert ist und die andere dieser Mantelschichten p-leitend dotiert ist,
- bei der die aktive Schichtstruktur mehrere Teilschichtstrukturen umfaßt, die durch Barriereschichten voneinander getrennt sind,
- bei der diese Barriereschichten eine Materialzusammensetzung aufweisen, die eine höhere Energiebandlücke besitzt als die daran angrenzenden Materialzusammensetzungen der Teilschichtstrukturen, so daß jede Teilschichtstruktur mit jeweils daran angrenzenden Barriereschichten einen Potentialtopf bildet,
- bei der diese Barriereschichten mindestens so dick sind, daß zur Ausbildung einer MQW-Struktur diese Potentialtöpfe voneinander entkoppelt sind,
- bei der jede Teilschichtstruktur eine Materialzusammensetzung aufweist, die in Richtung senkrecht zur Ebene der Schichten kontinuierlich oder in mindestens einer Stufe derart variiert, daß der gebildete Potentialtopf in dieser Richtung asymmetrisch ist,
- bei der in jeder Teilschichtstruktur dasjenige Halbleitermaterial mit der Materialzusammensetzung geringster Energiebandlücke sich näher zur n-leitend dotierten Mantelschicht befindet als das restliche Halbleitermaterial dieser Teilschichtstruktur,
- bei der die Materialzusammensetzungen in jeder Teilschichtstruktur so an die räumliche Struktur dieser Teilschichtstruktur angepaßt sind, daß durch Anlegen einer Potentialdifferenz in der durch die Dotierungen der Mantelschichten definierten Sperrichtung an einen für eine Modulation der erzeugten Strahlung vorgesehenen Bereich der aktiven Schichtstruktur eine Vergrößerung der Energiebandlücke der Teilschichtstrukturen in diesem Bereich bewirkt werden kann, und
- bei der mindestens drei Kontakte (7, 8, 9) vorhanden sind, die jeweils mit einer dieser Mantelschichten elektrisch leitend verbunden und so angeordnet sind, daß an einen für Strahlungserzeugung vorgesehenen Bereich der aktiven Schichtstruktur eine Potentialdifferenz und in den für eine Modulation der erzeugten Strahlung vorgesehenen Bereich der aktiven Schichtstruktur eine andere Potentialdifferenz angelegt werden kann.

2. Monolithische Laser-Modulator-Kombination nach Anspruch 1,
- bei der in der senkrecht zu der Ebene der Schichten vorgenommenen Projektion des für Strahlungserzeugung vorgesehenen Anteils der aktiven Schichtstruktur ein DFB-Gitter (4) angeordnet ist.

3. Monolithische Laser-Modulator-Kombination nach Anspruch 1 oder 2,
- bei der zwischen einem für Strahlungserzeugung vorgesehenen Anteil der aktiven Schichtstruktur und einem für eine Modulation der erzeugten Strahlung vorgesehenen Anteil der aktiven Schichtstruktur ein Trenngraben vorhanden ist und
- dieser Trenngraben eine Spiegelendfläche zur Ausbildung eines Laserresonators in dem für Strahlungserzeugung vorgesehenen Anteil der aktiven Schichtstruktur bildet.

4. Monolithische Laser-Modulator-Kombination nach einem der Ansprüche 1 bis 3,
- bei der zwei der Kontakte (7, 8) auf je einem von zwei voneinander elektrisch isolierten Bereichen (6a, 6b) einer der Mantelschichten aufgebracht sind.

5. Monolithische Laser-Modulator-Kombination nach einem der Ansprüche 1 bis 4,
- bei der die aktive Schichtstruktur in einem Materialsystem aus der Gruppe von InGaAsP, AlGaAs, Antimonidverbindungen und II-VI-Verbindungen ausgeführt ist.

6. Monolithische Laser-Modulator-Kombination nach einem der Ansprüche 1 bis 5,
- bei der jede Teilschichtstruktur aus drei Teilschichten besteht und
- bei der die mittlere dieser Teilschichten eine Materialzusammensetzung aufweist, die eine größere Energiebandlücke besitzt als die Materialzusammensetzungen der beiden anderen dieser Teilschichten.

7. Monolithische Laser-Modulator-Kombination nach Anspruch 6,
- bei der die Materialzusammensetzung der Barriereschichten zumindest näherungsweise In_{0,8}Ga_{0,2}As_{0,2}P_{0,8} ist,
- bei der die Materialzusammensetzung der mittleren Teilschicht zumindest näherungsweise In_{0,72}Ga_{0,28}As_{0,63}P_{0,37} ist,
- bei der die Materialzusammensetzung der zwischen der mittleren Teilschicht und der n-leitend dotierten Mantelschicht angeordneten Teilschicht zumindest näherungsweise In_{0,67}Ga_{0,33}As_{0,93}P_{0,07} ist und
- bei der die Materialzusammensetzung der zwischen der mittleren Teilschicht und der p-leitend dotierten Mantelschicht angeordneten Teilschicht zumindest näherungsweise In_{0,95}Ga_{0,05}As_{0,51}P_{0,49} ist.

8. Monolithische Laser-Modulator-Kombination nach Anspruch 6,
- bei der die Materialzusammensetzung der Barriereschichten zumindest näherungsweise In_{0,66}Ga_{0,34}As_{0,63}P_{0,37} ist,
- bei der die Materialzusammensetzung der mittleren Teilschicht zumindest näherungsweise In_{0,66}Ga_{0,34}As_{0,63}P_{0,37} ist,
- bei der die Materialzusammensetzung der zwischen der mittleren Teilschicht und der n-leitend dotierten Mantelschicht angeordneten Teilschicht zumindest näherungsweise In_{0,74}Ga_{0,26}As_{0,87}P_{0,13} ist und
- bei der die Materialzusammensetzung der zwischen der mittleren Teilschicht und der p-leitend dotierten Mantelschicht angeordneten Teilschicht zumindest näherungsweise InAs_{0,53}P_{0,47} ist.

9. Monolithische Laser-Modulator-Kombination nach einem der Ansprüche 1 bis 5,
- bei der jede Teilschichtstruktur aus zwei Teilschichten gebildet wird,
- bei der die Materialzusammensetzung der Barriereschichten zumindest näherungsweise In_{0,87}Ga_{0,13}As_{0,51}P_{0,49} ist,
- bei der die Materialzusammensetzung der näher zu der n-leitend dotierten Mantelschicht angeordneten Teilschicht zumindest näherungsweise In_{0,59}Ga_{0,41}As_{0,86}P_{0,14} ist und
- bei der die Materialzusammensetzung der näher zu der p-leitend dotierten Mantelschicht angeordneten Teilschicht zumindest näherungsweise InAs_{0,53}P_{0,47} ist.

## Claims

1. Monolithic laser/modulator combination made of semiconductor material,
- in which an active layer structure (2) suitable for producing radiation is arranged between cladding layers (1, 6a, 6b),
- in which one of these cladding layers is doped with n-type conductance and the other of these cladding layers is doped with p-type conductance,
- in which the active layer structure comprises a plurality of sublayer structures which are separated from one another by barrier layers,
- in which these barrier layers have a material composition which has a greater energy bandgap than the adjacent material compositions of the sublayer structures, so that each sublayer structure forms a potential well with the respectively adjacent barrier layers,
- in which these barrier layers are at least thick enough for these potential wells to be decoupled from one another to form an MQW structure,
- in which each sublayer structure has a material composition which, in a direction perpendicular to the plane of the layers, varies continuously or in at least one step in such a way that the potential well formed is asymmetric in this direction,
- in which, in each sublayer structure, that semiconductor material having the material composition with the lowest energy bandgap is closest to the cladding layer doped with n-type conduction than the remaining semiconductor material of this sublayer structure,
- in which the material compositions in each sublayer structure are matched to the three-dimensional structure of this sublayer structure in such a way that, by applying a potential difference in the reverse-bias direction defined by the doping levels in the cladding layers to a region of the active layer structure intended for modulation of the radiation produced, it is possible to bring about an increase in the energy bandgaps of the sublayer structures in this region, and
- in which there at least three contacts (7, 8, 9), which are each electrically connected to one of these cladding layers and are arranged in such a way that one potential difference can be applied to a region of the active layer structure intended for radiation production, and another potential difference can be applied in the region of the active layer structure intended for modulation of the radiation produced.

2. Monolithic laser/modulator combination according to Claim 1,
- in which a DFB grating (4) is arranged in the projection, made perpendicular to the plane of the layers, of the portion of the active layer structure intended for radiation production.

3. Monolithic laser/modulator combination according to Claim 1 or 2,
- in which there is an isolating trench between a portion of the active layer structure intended for radiation production and a portion of the active layer structure intended for modulation of the radiation produced, and
- this isolating trench forms a mirror end face for creating a laser resonator in the portion of the active layer structure intended for radiation production.

4. Monolithic laser/modulator combination according to one of Claims 1 to 3,
- in which two of the contacts (7, 8) are applied to one of two regions (6a, 6b), electrically insulated from one another, of one of the cladding layers.

5. Monolithic laser/modulator combination according to one of Claims 1 to 4,
- in which the active layer structure is made in a material system from the following groups: InGaAsP, AlGaAs, antimony compounds and II-VI compounds.

6. Monolithic laser/modulator combination according to one of Claims 1 to 5,
- in which each sublayer structure is composed of three sublayers, and
- in which the middle one of these sublayers has a material composition which has a greater energy bandgap than the material compositions of the other two of these sublayers.

7. Monolithic laser/modulator combination according to Claim 6,
- in which the material composition of the barrier layers is at least approximately In_{0.8}Ga_{0.2}As_{0.2}P_{0.8},
- in which the material composition of the middle sublayer is at least approximately In_{0.72}Ga_{0.28}As_{0.63} P_{0.37},
- in which the material composition of the sublayer arranged between the middle sublayer and the cladding layer doped with n-type conductance is at least approximately In_{0.67}Ga_{0.33}As_{0.93}P_{0.07}, and
- in which the material composition of the sublayer arranged between the middle sublayer and the cladding layer doped with p-type conductance is at least approximately In_{0.95}Ga_{0.05}As_{0.51}P_{0.49}.

8. Monolithic laser/modulator combination according to Claim 6,
- in which the material composition of the barrier layers is at least approximately In_{0.66}Ga_{0.34}As_{0.63}P_{0.37},
- in which the material composition of the middle sublayer is at least approximately In_{0.66}Ga_{0.34}As_{0.63}P_{0.37},
- in which the material composition of the sublayer arranged between the middle sublayer and the cladding layer doped with n-type conductance is at least approximately In_{0.74}Ga_{0.26}As_{0.87}P_{0.13} and
- in which the material composition of the sublayer arranged between the middle sublayer and the cladding layer doped with p-type conductance is at least approximately InAs_{0.53}P_{0.47}.

9. Monolithic laser/modulator combination according to one of Claims 1 to 5,
- in which each sublayer structure is formed from two sublayers,
- in which the material composition of the barrier layers is at least approximately In0.87Ga0.13As0.51P0.49,
- in which the material composition of the sublayer arranged closer to the cladding layer doped with n-type conductance is at least approximately In_{0.59}Ga_{0.41}As_{0.86} P_{0.14}, and
- in which the material composition of the sublayer arranged closer to the cladding layer doped with p-type conductance is at least approximately InAs_{0.53}P_{0.47}.

## Revendications

1. Combinaison monolithique laser-modulateur en matériau semi-conducteur, dans laquelle
- une structure en couches active (2) convenant à la production de rayonnement est interposée entre des couches latérales (1, 6a, 6b),
- l'une de ces couches latérales est à dopage de type n et l'autre de ces couches latérales est à dopage de type p,
- la structure en couches active comprend plusieurs structures en sous-couches, qui sont séparées les unes des autres par des couches barrières,
- ces couches barrières ont une composition de matériau qui a un plus grand écart énergétique que les compositions de matériau adjacentes des structures en sous-couches de telle sorte que chaque structure en sous-couches forme avec des couches barrières respectivement adjacentes un puits de potentiel,
- ces couches barrières sont au moins si épaisses que ces puits de potentiel sont découplés les uns des autres afin de former une structure MQW,
- chaque structure en sous-couches a une composition de matériau qui varie dans la direction perpendiculaire au plan des couches de manière continue ou au moins en un palier de telle sorte que le puits de potentiel formé est dissymétrique dans cette direction,
- dans chaque structure en sous-couches, le matériau semi-conducteur ayant la composition de matériau de plus petit écart énergétique se trouve plus près de la couche latérale à dopage de type n que le reste du matériau semi-conducteur de cette structure en sous-couches,
- les compositions de matériau dans chaque structure en sous-couches sont adaptées à la structure spatiale de cette structure en sous-couches de telle sorte que l'application d'une différence de potentiel dans le sens de non-conduction défini par les dopages des couches latérales à une zone, prévue pour une modulation du rayonnement produit, de la structure en couches active peut provoquer une augmentation de l'écart énergétique des structures en sous-couches dans cette zone, et
- il existe au moins trois contacts (7, 8, 9) qui sont reliés de façon électriquement conductrice chacun à l'une de ces couches latérales et qui sont disposés de telle sorte qu'une différence de potentiel peut être appliquée à une zone, prévue pour la production de rayonnement, de la structure en couches active et qu'une autre différence de potentiel peut être appliquée à une zone, prévue pour une modulation du rayonnement produit, de la structure en couches active.

2. Combinaison monolithique laser-modulateur selon la revendication 1, dans laquelle
- un réseau DFB (4) est prévu dans la projection, effectuée perpendiculairement au plan des couches, de la partie, prévue pour la production de rayonnement, de la structure en couches active.

3. Combinaison monolithique laser-modulateur selon la revendication 1 ou 2, dans laquelle
- une rainure de séparation se trouve entre une partie, prévue pour la production de rayonnement, de la structure en couches active et une partie, prévue pour une modulation du rayonnement produit, de la structure en couches active, et
- cette rainure de séparation forme une surface terminale en miroir pour former un résonateur laser dans la partie, prévue pour la production de rayonnement, de la structure en couches active.

4. Combinaison monolithique laser-modulateur selon l'une des revendications 1 à 3, dans laquelle
- deux des contacts (7, 8) sont appliqués sur respectivement une des deux zones (6a, 6b), isolées électriquement l'une de l'autre, de l'une des couches latérales.

5. Combinaison monolithique laser-modulateur selon l'une des revendications 1 à 4, dans laquelle
- la structure en couches active est mise en oeuvre dans un système de matériau pris parmi le groupe: InGaAsP, AlGaAs, composés d'antimoine et composés II-VI.

6. Combinaison monolithique laser-modulateur selon l'une des revendications 1 à 5, dans laquelle
- chaque structure en sous-couches est constituée de trois sous-couches, et
- la sous-couche médiane parmi ces sous-couches a une composition de matériau qui a un plus grand écart énergétique que les compositions de matériau des deux autres sous-couches.

7. Combinaison monolithique laser-modulateur selon la revendication 6, dans laquelle
- la composition de matériau des couches barrières est au moins approximativement In_{0,8}Ga_{0,2}As_{0,2}P_{0,8},
- la composition de matériau de la sous-couche médiane est au moins approximativement In_{0,72}Ga_{0,28}As_{0,63}P_{0,37},
- la composition de matériau de la sous-couche interposée entre la sous-couche médiane et la couche latérale à dopage de type n est au moins approximativement In_{0,67}Ga_{0,33}As_{0,93}P_{0,07} et
- la composition de matériau de la sous-couche agencée entre la sous-couche médiane et la couche latérale à dopage de type p est au moins approximativement In_{0,95}Ga_{0,05}As_{0,51} P_{0,49}.

8. Combinaison monolithique laser-modulateur selon la revendication 6, dans laquelle
- la composition de matériau des couches barrières est au moins approximativement In_{0,66}Ga_{0,34}As_{0,63}P_{0,37},
- la composition de matériau de la sous-couche médiane est au moins approximativement In_{0,66}Ga_{0,34}As_{0,63}P_{0,37},
- la composition de matériau de la sous-couche interposée entre la sous-couche médiane et la couche latérale à dopage de type n est au moins approximativement In_{0,74}Ga_{0,26}As_{0,87}P_{0,13} et
- la composition de matériau de la sous-couche interposée entre la sous-couche médiane et la couche latérale à dopage de type p est au moins approximativement InAs_{0,53}P_{0,47}.

9. Combinaison monolithique laser-modulateur selon l'une des revendications 1 à 5, dans laquelle
- chaque structure en sous-couches est formée par deux sous-couches,
- la composition de matériau des couches barrières est au moins approximativement In_{0,87}Ga_{0,13}As_{0,51}P_{0,49},
- la composition de matériau de la sous-couche prévue près de la couche latérale à dopage de type n est au moins approximativement In_{0,59}Ga_{0,41}As_{0,86}P_{0,14} et
- la composition de matériau de la sous-couche prévue près de la couche latérale à dopage de type p est au moins approximativement InAs_{0,53}P_{0,47}.
